# EUROPÄISCHE PATENTSCHRIFT

(11) **EP 3 876 368 B1**
(45) Veröffentlichungstag und Bekanntmachung des Hinweises auf die Patenterteilung: **14.05.2025**
(21) Anmeldenummer: 21160423.6
(22) Anmeldetag: 09.07.2010
(51) Int. Cl.: H01S 5/50, H01S 3/00, G02B 6/27, H01S 3/10, H01S 3/23

(54) **VORRICHTUNG ZUM VERSTÄRKEN UND/ODER TRANSPORTIEREN VON ELEKTROMAGNETISCHER STRAHLUNG**
DEVICE FOR AMPLIFYING AND / OR TRANSPORTING ELECTROMAGNETIC RADIATION
DISPOSITIF DE RENFORCEMENT ET/OU DE TRANSPORT DU RAYONNEMENT ÉLECTROMAGNÉTIQUE

(30) Priorität: 10.07.2009 DE 102009032803
(43) Veröffentlichungstag der Anmeldung: 08.09.2021
(62) Teilanmeldung aus: 10757150.7
(73) Patentinhaber: Fraunhofer-Gesellschaft zur Förderung der angewandten Forschung e.V., 80686 München (DE); Friedrich-Schiller-Universität Jena, 07743 Jena (DE)
(72) Erfinder: Limpert, Jens, 07751 Jena (DE); Tünnermann, Andreas, 99425 Weimar (DE); Schimpf, Damian N., Cambridge, 02139 (US); Eidam, Tino, 07751 Jena (DE); Seise, Enrico, 07639 Tautenhain (DE); Röser, Fabian, 01097 Dresden (DE)
(74) Vertreter: Schneiders & Behrendt Bochum

(56) Entgegenhaltungen:
- DE-A1- 10 116 076
- US-A- 5 513 194
- US-A1- 2001 017 867
- US-B1- 6 229 937
- ANONYMOUS, SPIE, PO BOX 10 BELLINGHAM WA 98227-0010 USA, 17 February 1010 (1010-02-17), XP040517654
- CAO X D ET AL: "OPTIMIZATION OF PULSE SHAPING USING NONLINEAR POLARIZATION ROTATION", OPTICS COMMUNICATIONS, ELSEVIER, AMSTERDAM, NL, vol. 120, no. 5/06, 1 November 1995 (1995-11-01), pages 316 - 320, XP000529076, ISSN: 0030-4018, DOI: 10.1016/0030-4018(95)00440-J
- N. MINKOVSKI ET AL., SPIE, PO BOX 10 BELLINGHAM WA 98227-0010 USA, 11 November 2009 (2009-11-11), XP040515107

## Beschreibung

Die Erfindung betrifft eine Vorrichtung zum Verstärken von elektromagnetischer Strahlung, mit einer Strahlungsquelle zum Erzeugen der elektromagnetischen Strahlung sowie einem Verstärker zum Verstärken der erzeugten elektromagnetischen Strahlung.

Derartige Vorrichtungen sind bekannt und finden beispielsweise Einsatz bei der Erzeugung hochenergetischer Laserstrahlung. Die Qualität der elektromagnetischen Strahlung wird beim Verstärken und/oder Transportieren derselben meist durch das Auftreten von Dispersion und/oder nichtlinearen Effekten beeinträchtigt. Während der Einfluss der Dispersion in der Regel gut kompensierbar ist, verursachen nichtlineare Effekte eine deutliche Verschlechterung der Qualität der Laserstrahlung. Der hierbei dominante nichtlineare Effekt ist der Kerr-Effekt. Dieser zeigt sich beispielsweise in Form von Selbstphasenmodulation. Der Kerr-Effekt ist u. a. proportional zur Spitzenintensität sowie zur Wechselwirkungslänge im Verstärker beziehungsweise Transportmedium. Um den Einfluss der Kerr-Nichtlinearität zu reduzieren, ist es bekannt, beispielsweise für die Erzeugung von ultrakurzen Laserimpulsen zeitlich gestreckte Laserimpulse, auch gechirpte Laserimpulse genannt, zu verwenden und diese gechirpten Laserimpulse anschließend zu verstärken. Diese Methode findet bei den so genannten CPA-Systemen (Chirped Pulse Amplification) Anwendung, bei denen die verstärkten Laserimpulse zuletzt meist noch zeitlich komprimiert werden. Des Weiteren ist es bekannt, die durch nichtlineare Effekte hervorgerufene nichtkomprimierbare Phase mit Hilfe von Pulsformung zu kontrollieren.

Die Auswirkungen der nichtlinearen Effekte treten in optischen Fasern bereits bei sehr geringen Leistungen auf, da die Laserstrahlung in Form von Moden geführt wird. Einerseits wird die Laserstrahlung auf kleine Modenfeldflächen gebunden, was zu hohen Intensitäten führt, andererseits breitet sich die Laserstrahlung quasi-beugungsfrei aus, was wiederum zu großen Wechselwirkungslängen führt. Da die Selbstphasenmodulation umgekehrt proportional zur Modenfeldfläche und proportional zur Faserlänge ist, kann die Verwendung von neuartigen mikrostrukturierten Fasern, wie z.B. LMA-Fasern (Large Mode-Area Fibers) oder LMA-PCF-Fasern (Large Mode-Area Photonic Crystal Fiber), mit großer Modenfeldfläche bei gleichzeitig kleiner Faserlänge den Einfluss nichtlinearer Effekte stark reduzieren.

Nachteilig bei den bekannten Methoden zur Reduzierung der nichtlinearen Effekte ist, dass relativ komplizierte und kostenintensive bauliche Veränderungen an vorhandenen Vorrichtungen vorgenommen werden müssen, um das gewünschte Ergebnis zu erhalten. Auch die mit diesen Veränderungen verbundene Anpassung der einzelnen Komponenten untereinander ist relativ aufwändig.

Das Dokument US 2001/017867 offenbart eine Vorrichtung zum Verstärken von elektromagnetischer Strahlung, mit einer Strahlungsquelle zum Erzeugen der EM Strahlung sowie einem Faserverstärker zum Verstärken der EM Strahlung, die im Verstärker nicht linear, sondern zirkular polarisiert ist, wobei der Verstärker der EM Strahlung eine durch nichtlineare Effekte bedingte nichtlineare Phase aufpräg.

Hiervon ausgehend ist es die Aufgabe der Erfindung, eine Vorrichtung zum Verstärken beziehungsweise Transportieren von elektromagnetischer Strahlung bereitzustellen, welche eine sehr einfach realisierbare und kostengünstige Möglichkeit zur Reduzierung des Einflusses von nichtlinearen Effekten bietet.

Diese Aufgabe wird ausgehend von einer Vorrichtung wie in Anspruch 1 beschrieben.

Die Erfindung beruht auf der Erkenntnis, dass der Koeffizient der nichtlinearen Brechzahl von der Polarisation der elektromagnetischen Strahlung abhängt. Dieser Koeffizient ist bei linear polarisierter elektromagnetischer Strahlung etwa 1,5-mal so groß wie bei zirkular polarisierter elektromagnetischer Strahlung. Somit können durch den erfindungsgemäßen Ansatz nichtlineare Effekte wie beispielsweise Selbstphasenmodulation, Kreuzphasenmodulation, Selbstfokussierung, Vierwellen-Mischung und ähnliches reduziert werden. Der erfindungsgemäße Ansatz zur Reduzierung nichtlinearer Effekte ist vergleichsweise einfach und kann zudem in vorhandene Systeme übernommen werden, ohne aufwändige bauliche Modifikationen vornehmen zu müssen. Darüber hinaus kann der erfindungsgemäße Ansatz nahezu problemlos mit den oben beschriebenen herkömmlichen Vorgehensweisen zur Reduzierung von nichtlinearen Effekten kombiniert werden. Von Vorteil ist dabei unter anderem, dass eine Reduzierung der nichtlinearen Effekte zu einer Erhöhung der Spitzenleistung der elektromagnetischen Strahlung führt. Des Weiteren kann die Schwelle für Selbstfokussierung nach oben verschoben werden.

Die im Verstärker propagierende elektromagnetische Strahlung ist elliptisch oder zirkular polarisiert.

Nach einer vorteilhaften Ausgestaltung der Erfindung ist vorgesehen, dass die Strahlungsquelle linear polarisierte elektromagnetische Strahlung erzeugt und im Strahlengang zwischen der Strahlungsquelle und dem Verstärker ein Polarisationswandler angeordnet ist. Der Polarisationswandler begünstigt hierbei, dass die linear polarisierte elektromagnetische Strahlung derart gewandelt wird, dass die im Verstärker propagierende elektromagnetische Strahlung weitgehend nicht linear polarisiert ist.

Der Verstärker, beispielsweise eine optische Glasfaser, prägt der elektromagnetischen Strahlung eine durch nichtlineare Effekte bedingte nichtlineare Phase auf. Diese Phase kann durch den erfindungsgemäßen Ansatz auf einfache Art und Weise deutlich reduziert werden, um so die Qualität beziehungsweise Leistung der verstärkten elektromagnetischen Strahlung zu erhöhen.

Der Polarisationswandler ist vorzugsweise als Viertelwellenplatte ausgebildet. Dies stellt eine sehr einfache und kostengünstige Realisierungsmöglichkeit dar.

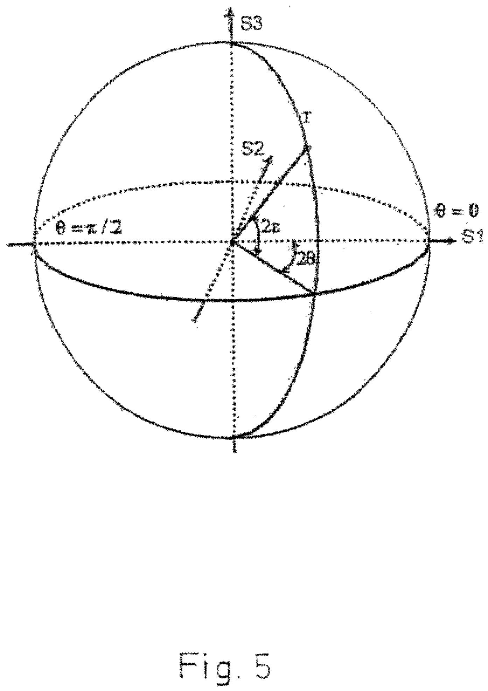

Nach einer weiteren vorteilhaften Ausgestaltung der Erfindung ist der Polarisationszustand der im Verstärker propagierenden elektromagnetischen Strahlung durch die Lage r > 0.9 einerseits und |*ε*| > 30°, |*ε*| > 35° oder |*ε*| > 40° andererseits auf der Poincaré-Kugel bestimmt. Die Wahl eines dieser Polarisationszustände hat sich als besonders geeignet zur Reduzierung der nichtlinearen Effekte herausgestellt. Es können jedoch auch andere Polarisationszustände ausgewählt werden, welche auf den jeweiligen Anwendungsfall ideal zugeschnitten sind. Zur Verdeutlichung der Parameterwahl wird auf die in Figur 5 gezeigte Poincaré-Kugel-Darstellung verwiesen, bei der sich linear polarisierte elektromagnetische Strahlung am Äquator befindet, wohingegen zirkular polarisierte elektromagnetische Strahlung an den Polen zu finden ist.

Die Erfindung sieht vor, dass der Verstärker ein weitgehend optisches isotropes Medium aufweist. Erfindugsgemäss ist dieses Medium ein Wellenleiter, oder ein Gas. Der erfindungsgemäße Ansatz zur Reduzierung der nichtlinearen Effekte hat sich für solche Medien als besonders wirksam und vorteilhaft herausgestellt.

Gemäß einer weiteren vorteilhaften Ausgestaltung der Erfindung ist die elektromagnetische Strahlung aus gepulsten elektromagnetischen Strahlungsimpulsen oder aus einer kontinuierlichen elektromagnetischen Strahlung gebildet. Das Auftreten von nichtlinearen Effekten ist bei beiden Arten elektromagnetischer Strahlung festzustellen. Die erfindungsgemäße Reduzierung der nichtlinearen Effekte findet bei beiden Strahlungsarten gleichermaßen Anwendung und führt zu ähnlich guten Ergebnissen.

Nach einer weiteren vorteilhaften Ausgestaltung der Erfindung ist im Strahlengang zwischen Strahlungsquelle und Polarisationswandler ein Polarisationsteiler angeordnet und dem Verstärker ein Spiegel nachgeschaltet, wobei der Spiegel die Strahlungsrichtung der verstärkten elektromagnetischen Strahlung umkehrt. Bei dieser Ausgestaltung der Erfindung ist die Verwendung einer Strahlungsquelle von Vorteil, die linear polarisierte elektromagnetische Strahlung erzeugt. Die erzeugte elektromagnetische Strahlung wird zunächst durch den Polarisationsteiler, beispielsweise einen Polarisationsteilerwürfel, geführt und anschließend mittels des Polarisationswandlers in nicht linear polarisierte elektromagnetische Strahlung gewandelt. Diese wird anschließend mittels des Verstärkers, beispielsweise eines Faserverstärkers, verstärkt. Hierbei können nichtlineare Effekte im Verstärker auftreten, die durch die erfindungsgemäße Wahl der im Verstärker propagierenden, weitgehend nicht linear polarisierten elektromagnetischen Strahlung deutlich reduzierbar sind. Die verstärkte, weitgehend nicht linear polarisierte elektromagnetische Strahlung wird anschließend an dem Spiegel zurückreflektiert und erneut mittels des Verstärkers verstärkt, wobei auch bei dieser zweiten Verstärkungsstufe durch die Wahl von weitgehend nicht linear polarisierter elektromagnetischer Strahlung sehr geringe nichtlineare Effekte auftreten. Die zweifach verstärkte, weitgehend nicht linear polarisierte elektromagnetische Strahlung passiert anschließend wieder den Polarisationswandler und wird zu verstärkter, linear polarisierter elektromagnetischer Strahlung, deren Polarisationsebene senkrecht zu der der anfänglichen unverstärkten, linear polarisierten elektromagnetischen Strahlung steht. Die zweifach verstärkte, linear polarisierte elektromagnetische Strahlung wird schließlich über den Polarisationsteiler zu ihrer weiteren Verwendung aus der Vorrichtung ausgekoppelt. Diese Ausgestaltung der Vorrichtung ist somit bei relativ kompaktem Aufbau sehr effektiv.

Alternativ wird vorgeschlagen, dass dem Verstärker ein weiterer Polarisationswandler nachgeschaltet ist, der die weitgehend nicht linear polarisierte elektromagnetische Strahlung in linear polarisierte elektromagnetische Strahlung wandelt. Bei dieser Ausgestaltung passiert die elektromagnetische Strahlung lediglich einmal den Verstärker.

Es wird weiter vorgeschlagen, dass im Strahlengang zwischen Polarisationswandler und Verstärker ein Strecker zum zeitlichen Strecken der elektromagnetischen Strahlungsimpulse angeordnet und dem Verstärker beziehungsweise dem weiteren Polarisationswandler ein Kompressor zum Komprimieren der verstärkten elektromagnetischen Strahlungsimpulse nachgeschaltet ist. Diese Ausgestaltung der Erfindung betrifft die Umsetzung des Erfindungsgedankens in einem CPA-System mit den damit verbundenen Vorteilen.

Weiterhin wird vorgeschlagen, dass im Strahlengang zwischen Strahlungsquelle und Verstärker ein Strecker zum zeitlichen Strecken der elektromagnetischen Strahlungsimpulse angeordnet und dem Verstärker beziehungsweise weiteren Polarisationswandler ein Kompressor zum zeitlichen Komprimieren der verstärkten elektromagnetischen Strahlungsimpulse nachgeschaltet ist.

Ferner wird vorgeschlagen, dass die Vorrichtung zum spektralen Formen der elektromagnetische Strahlungsimpulse eingerichtet ist.

Mit der Erfindung wird somit eine Vorrichtung bereitgestellt, welche auf sehr einfache und kostengünstige Art und Weise der Reduzierung von nichtlinearen Effekten bei der Verstärkung von elektromagnetischer Strahlung dient und gleichzeitig problemlos mit vorhandenen Vorrichtungen sowie mit weiteren Methoden zur Reduzierung von nichtlinearen Effekten kombinierbar ist.

Weitere Vorteile und Merkmale der vorliegenden Erfindung werden anhand der in den Figuren gezeigten Ausführungsbeispiele näher erläutert. Dabei zeigen
- Figur 1:: ein Ausführungsbeispiel für die erfindungsgemäße Vorrichtung,
- Figur 2:: ein weiteres Ausführungsbeispiel für die erfindungsgemäße Vorrichtung,
- Figur 3:: ein weiteres Ausführungsbeispiel für die erfindungsgemäße Vorrichtung,
- Figur 4:: ein weiteres Ausführungsbeispiel für die erfindungsgemäße Vorrichtung, und
- Figur 5:: eine Darstellung der Poincaré-Kugel.

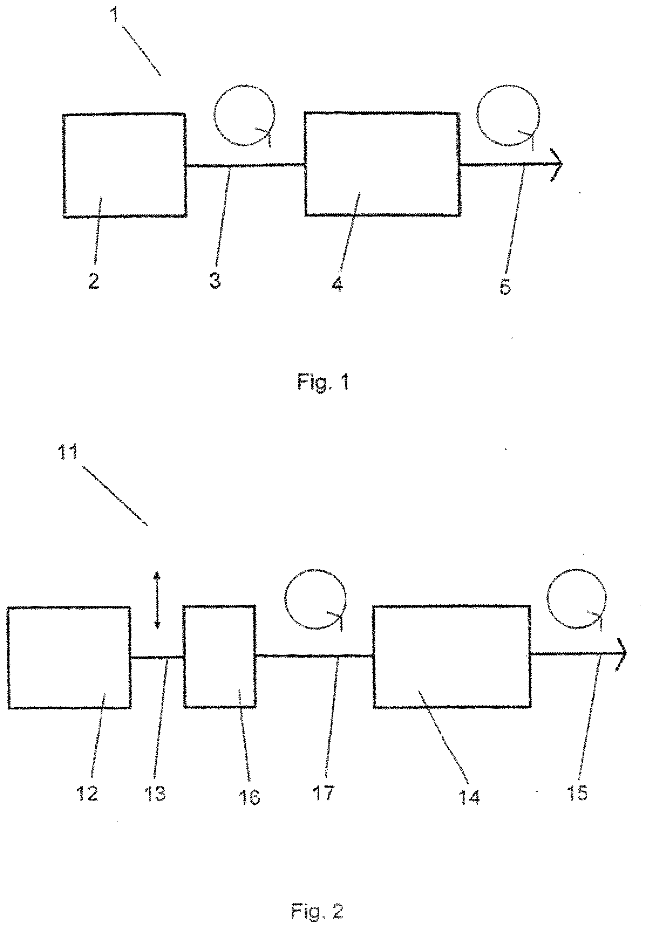

Figur 1 zeigt ein erstes Ausführungsbeispiel für die erfindungsgemäße Vorrichtung 1. Diese weist eine Strahlungsquelle 2 auf, welche weitgehend nicht linear polarisierte elektromagnetische Strahlung in Form von zirkular oder elliptisch polarisierter elektromagnetischer Strahlung 3 erzeugt. Die zirkular oder elliptisch polarisierte elektromagnetische Strahlung 3 wird anschließend mittels des Verstärkers 4 verstärkt. Die hierbei auftretenden nichtlinearen Effekte sind durch die Verwendung von zirkular oder elliptisch polarisierter elektromagnetischer Strahlung 3 deutlich reduziert.

Figur 2 zeigt ein weiteres Ausführungsbeispiel für die erfindungsgemäße Vorrichtung 11. Diese weist eine Strahlungsquelle 12 zum Erzeugen von linear polarisierter elektromagnetischer Strahlung 13 auf. Die linear polarisierte elektromagnetische Strahlung 13 wird anschließend von einem im Strahlengang zwischen der Strahlungsquelle 12 und dem Verstärker 14 angeordneten Polarisationswandler 16 in zirkular oder elliptisch polarisierte elektromagnetische Strahlung 17 gewandelt. Die zirkular oder elliptisch polarisierte elektromagnetische Strahlung 17 wird dann mittels des Verstärkers 14 verstärkt, wobei verstärkte, zirkular oder elliptisch polarisierte elektromagnetische Strahlung 15 entsteht. Diese Ausführungsform der erfindungsgemäßen Vorrichtung 11 kann alternativ zu der in Figur 1 gezeigten eingesetzt werden.

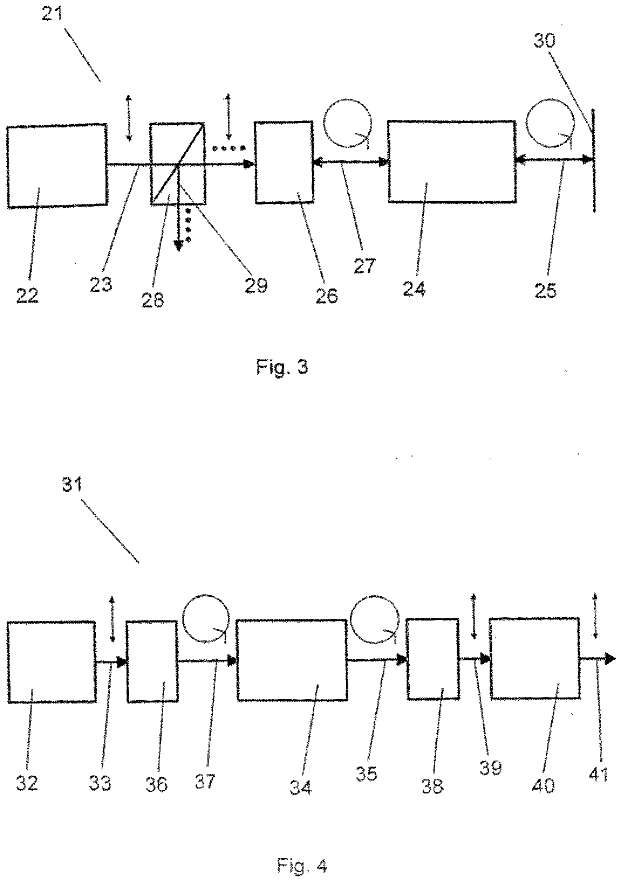

Figur 3 zeigt ein weiteres Ausführungsbeispiel für die erfindungsgemäße Vorrichtung 21. Bei dieser Ausführungsform findet eine Strahlungsquelle 22 Einsatz, welche linear polarisierte elektromagnetische Strahlung 23 erzeugt. Diese linear polarisierte elektromagnetische Strahlung 23 wird anschließend durch einen Polarisationsteiler 28 geführt, welcher für linear polarisierte elektromagnetische Strahlung 23 in dem Polarisationszustand, wie er von der Strahlungsquelle 22 erzeugt wird, durchlässig ist. Die durch den Polarisationsteiler 28 durchgelassene linear polarisierte elektromagnetische Strahlung 23 wird anschließend mittels des Polarisationswandlers 26 in zirkular oder elliptisch polarisierte elektromagnetische Strahlung 27 gewandelt. Diese zirkular oder elliptisch polarisierte elektromagnetische Strahlung 27 wird anschließend mittels des Verstärkers 24 verstärkt. Die verstärkte, zirkular oder elliptisch polarisierte elektromagnetische Strahlung 25 wird anschließend an einem Spiegel 30 reflektiert, der die Strahlungsrichtung der verstärkten, zirkular oder elliptisch polarisierten elektromagnetischen Strahlung 25 umkehrt. Die reflektierte verstärkte, zirkular oder elliptisch polarisierte elektromagnetische Strahlung 25 wird erneut vom Verstärker 24 verstärkt und anschließend mittels des Polarisationswandlers 26 in linear polarisierte elektromagnetische Strahlung 29 gewandelt, deren Polarisationsebene jedoch senkrecht zu der von der Strahlungsquelle 22 erzeugten ursprünglichen linear polarisierten elektromagnetischen Strahlung 23 ist, was durch die Punkte und Pfeile angedeutet sein soll. Die zweifach verstärkte, linear polarisierte elektromagnetische Strahlung 29 wird anschließend über den Polarisationsteiler 28 aus der Vorrichtung 21 ausgekoppelt.

Eine weitere Ausführungsform der erfindungsgemäßen Vorrichtung 31 ist in Figur 4 gezeigt. Bei dieser Ausführungsform erzeugt die Strahlungsquelle 32 dispersiv gestreckte, linear polarisierte elektromagnetische Strahlung 33. Stattdessen kann aber auch vorgesehen sein, dass die Strahlungsquelle linear polarisierte elektromagnetische Strahlung erzeugt, welche anschließend mittels eines Streckers dispersiv gestreckt wird, der im Strahlengang der Strahlungsquelle nachgeschaltet ist. Die dispersiv gestreckte, linear polarisierte elektromagnetische Strahlung 33 wird anschließend mittels des Polarisationswandlers 36 in dispersiv gestreckte, zirkular oder elliptisch polarisierte elektromagnetische Strahlung 37 gewandelt. Diese wird daraufhin mittels des Verstärkers 34 verstärkt. Die verstärkte, dispersiv gestreckte, zirkular oder elliptisch polarisierte elektromagnetische Strahlung 35 wird mittels des dem Verstärker 34 nachgeschalteten weiteren Polarisationswandlers 38 wieder in dispersiv gestreckte, linear polarisierte elektromagnetische Strahlung 39 gewandelt. Diese wird zuletzt mittels eines Kompressors 40 zeitlich komprimiert, was die Abgabe von hochenergetischer, linear polarisierter elektromagnetischer Strahlung 41 von hoher Qualität ermöglicht.

Die anhand der Figuren beschriebenen Ausführungsbeispiele dienen der Erläuterung und sind nicht beschränkend.

## Patentansprüche

1. Vorrichtung (1) zum Verstärken von elektromagnetischer Strahlung, mit einer Strahlungsquelle (2) zum Erzeugen der elektromagnetischen Strahlung sowie einem Verstärker (4) zum Verstärken der erzeugten elektromagnetischen Strahlung,
wobei die im Verstärker (4) propagierende elektromagnetische Strahlung weitgehend nicht linear, nämlich elliptisch oder zirkular polarisiert ist,
**dadurch gekennzeichnet, dass**
der Verstärker (14, 24, 34) der elektromagnetischen Strahlung eine durch nichtlineare Effekte bedingte nichtlineare Phase aufprägt, die im Vergleich zu der nichtlinearen Phase bei linearer Polarisation der elektromagnetischen Strahlung reduziert ist, und wobei der Verstärker (14, 24, 34) ein optisch isotropes Medium aufweist, wobei das optisch isotrope Medium ein Wellenleiter oder ein Gas ist.

2. Vorrichtung (11, 21, 31) nach Anspruch 1, **dadurch gekennzeichnet, dass** die Strahlungsquelle (12, 22, 32) linear polarisierte elektromagnetische Strahlung (13, 23, 33) erzeugt und im Strahlengang zwischen der Strahlungsquelle (12, 22, 32) und dem Verstärker (14, 24, 34) ein Polarisationswandler (16, 26, 36) angeordnet ist.

3. Vorrichtung (11, 21, 31) nach Anspruch 2, **dadurch gekennzeichnet, dass** der Polarisationswandler (16, 26, 36) eine Viertelwellenplatte ist.

4. Vorrichtung (1, 11, 31) nach Anspruch 2 oder 3, **dadurch gekennzeichnet, dass** dem Verstärker (4, 14, 34) ein weiterer Polarisationswandler (38) nachgeschaltet ist, der weitgehend nicht linear polarisierte elektromagnetische Strahlung (5, 15, 35) in linear polarisierte elektromagnetische Strahlung (39) wandelt.

5. Vorrichtung (11, 21, 31) nach einem der Ansprüche 2 bis 4, **dadurch gekennzeichnet, dass** im Strahlengang zwischen Polarisationswandler (16, 26, 36) und Verstärker (14, 24, 34) ein Strecker zum zeitlichen Strecken der elektromagnetischen Strahlungsimpulse angeordnet und dem Verstärker (14, 24, 34) bzw. dem weiteren Polarisationswandler (38) ein Kompressor (40) zum zeitlichen Komprimieren der verstärkten elektromagnetischen Strahlungsimpulse nachgeschaltet ist.

6. Vorrichtung (1) nach einem der Ansprüche 2 bis 5, **dadurch gekennzeichnet, dass** im Strahlengang zwischen Strahlungsquelle (2, 12, 22, 32) und Verstärker (4, 14, 24, 34) ein Strecker zum zeitlichen Strecken der elektromagnetischen Strahlungsimpulse angeordnet und dem Verstärker (4, 14, 24, 34) bzw. weiteren Polarisationswandler (38) ein Kompressor zum zeitlichen Komprimieren der verstärkten elektromagnetischen Strahlungsimpulse nachgeschaltet ist.

7. Vorrichtung (21) nach einem der Ansprüche 2 bis 6, **dadurch gekennzeichnet, dass** im Strahlengang zwischen Strahlungsquelle (22) und Polarisationswandler (26) ein Polarisationsteiler (28) angeordnet und dem Verstärker (24) ein Spiegel (30) nachgeschaltet ist, wobei der Spiegel (30) die Strahlungsrichtung der verstärkten elektromagnetischen Strahlung (25) umkehrt.

8. Vorrichtung (11, 21, 31) nach einem der Ansprüche 1 bis 7, **dadurch gekennzeichnet, dass** die elektromagnetische Strahlung aus gepulsten elektromagnetischen Strahlungsimpulsen oder aus einer kontinuierlichen elektromagnetischen Strahlung gebildet ist.

## Claims

1. A device (1) for amplifying electromagnetic radiation, comprising a radiation source (2) for generating the electromagnetic radiation and an amplifier (4) for amplifying the generated electromagnetic radiation,
wherein the electromagnetic radiation propagating in the amplifier (4) is polarised largely non-linearly, specifically elliptically or circularly,
**characterised in that**
the amplifier (14, 24, 34) of the electromagnetic radiation impresses a non-linear phase, caused by non-linear effects, which is reduced compared to the non-linear phase with linear polarisation of the electromagnetic radiation, and wherein the amplifier (14, 24, 34) comprises an optically isotropic medium, wherein the optically isotropic medium is a waveguide or a gas.

2. The device (11, 21, 31) according to claim 1, **characterised in that** the radiation source (12, 22, 32) generates linearly polarised electromagnetic radiation (13, 23, 33) and a polarisation converter is arranged in the beam path between the radiation source (12, 22, 32) and the amplifier (14, 24, 34).

3. The device (11, 21, 31) according to claim 2, **characterised in that** the polarisation converter (16, 26, 36) is a quarter-wave plate.

4. The device (1, 11, 31) according to claim 2 or 3, **characterised in that** a further polarisation converter (38) is arranged downstream of the amplifier (4, 14, 34) and converts largely non-linearly polarised electromagnetic radiation (5, 15, 35) into linearly polarised electromagnetic radiation (39).

5. The device (11, 21, 31) according to any one of claims 2 to 4, **characterised in that** a stretcher for temporal stretching of the electromagnetic radiation pulses is arranged in the beam path between polarisation converter (16, 26, 36) and amplifier (14, 24, 34) and a compressor (40) for temporal compression of the amplified electromagnetic radiation pulses is arranged downstream of the amplifier 914, 24, 34) or the further polarisation converter (38).

6. The device (1) according to any one of claims 2 to 5, **characterised in that** a stretcher for temporal stretching of the electromagnetic radiation pulses is arranged in the beam path between radiation source (2, 12, 22, 32) and amplifier (4, 14, 24, 34) and a compressor for temporal compression of the amplified electromagnetic radiation pulses is arranged downstream of the amplifier (4, 14, 24, 34) or further polarisation converter (38).

7. The device (21) according to any one of claims 2 to 6, **characterised in that** a polarisation splitter (28) is arranged in the beam path between radiation source (22) and polarisation converter (26) and a mirror (30) is arranged downstream of the amplifier (24), wherein the mirror (30) reverses the radiation direction of the amplified electromagnetic radiation (25).

8. The device (11, 21, 31) according to any one of claims 1 to 7, **characterised in that** the electromagnetic radiation is formed from pulsed electromagnetic radiation pulses or from a continuous electromagnetic radiation.

## Revendications

1. Dispositif (1) pour amplifier un rayonnement électromagnétique, avec une source de rayonnement (2) pour générer le rayonnement électromagnétique ainsi qu'un amplificateur (4) pour amplifier le rayonnement électromagnétique généré,
le rayonnement électromagnétique qui se propage dans l'amplificateur (4) étant largement polarisé de manière non linéaire, à savoir de manière elliptique ou circulaire,
**caracterisé en ce que**
l'amplificateur (14, 24, 34) imprime au rayonnement électromagnétique une phase non linéaire due à des effets non linéaires, qui est réduite en comparaison de la phase non linéaire en cas de polarisation linéaire du rayonnement électromagnétique, et dans lequel l'amplificateur (14, 24, 34) présente un milieu optiquement isotrope, le milieu optiquement isotrope étant un guide d'ondes ou un gaz.

2. Dispositif (11, 21, 31) selon la revendication 1, **caractérisé en ce que** la source de rayonnement (12, 22, 32) génère un rayonnement électromagnétique (13, 23, 33) polarisé de manière linéaire et un convertisseur de polarisation (16, 26, 36) est agencé sur le trajet du rayonnement entre la source de rayonnement (12, 22, 32) et l'amplificateur (14, 24, 34).

3. Dispositif (11, 21, 31) selon la revendication 2, **caractérisé en ce que** le convertisseur de polarisation (16, 26, 36) est une plaque quart d'onde.

4. Dispositif (1, 11, 31) selon la revendication 2 ou 3, **caractérisé en ce que** l'amplificateur (4, 14, 34) est suivi d'un autre convertisseur de polarisation (38) qui convertit un rayonnement électromagnétique (5, 15, 35) largement polarisé de manière non linéaire en un rayonnement électromagnétique (39) polarisé de manière linéaire.

5. Dispositif (11, 21, 31) selon l'une quelconque des revendications 2 à 4, **caractérisé en ce que** sur le trajet du rayonnement entre le convertisseur de polarisation (16, 26, 36) et l'amplificateur (14, 24, 34) est agencé un étireur pour étirer dans le temps les impulsions de rayonnement électromagnétique et, en aval de l'amplificateur (14, 1024, 34) ou de l'autre convertisseur de polarisation (38) est monté un compresseur (40) pour comprimer dans le temps les impulsions de rayonnement électromagnétique amplifiées.

6. Dispositif (1) selon l'une quelconque des revendications 2 à 5, **caractérisé en ce que** sur le trajet du rayonnement entre la source de rayonnement (2, 12, 22, 32) et l'amplificateur (4, 14, 24, 34) est agencé un étireur pour étirer dans le temps les impulsions de rayonnement électromagnétique et, en aval de l'amplificateur (4, 14, 24, 34) ou de l'autre convertisseur de polarisation (38) est monté un compresseur pour comprimer dans le temps les impulsions de rayonnement électromagnétique amplifiées.

7. Dispositif (21) selon l'une quelconque des revendications 2 à 6, **caractérisé en ce qu'**un diviseur de polarisation (28) est agencé sur le trajet du rayonnement entre la source de rayonnement (22) et le convertisseur de polarisation (26) et un miroir (30) est monté en aval de l'amplificateur (24), le miroir (30) inversant la direction de rayonnement du rayonnement électromagnétique amplifié (25).

8. Dispositif (11, 21, 31) selon l'une quelconque des revendications 1 à 7, **caractérisé en ce que** le rayonnement électromagnétique est formé d'impulsions de rayonnement électromagnétique pulsées ou d'un rayonnement électromagnétique continu.
